# EUROPEAN PATENT APPLICATION

(11) **EP 4 567 431 A1**
(43) Date of publication of application: **11.06.2025**
(21) Application number: 24212105.1
(22) Date of filing: 11.11.2024
(51) Int. Cl.: G01P 1/00, G01P 1/02, G01P 21/00, G01D 11/26

(54) **ELECTRICAL DEVICE THERMAL REGULATION SYSTEM WITH THERMOELECTRIC COOLER MODULE**

(30) Priority: 04.12.2023 US 202318528285
(71) Applicant: Honeywell International Inc., Charlotte, NC 28202 (US)
(72) Inventor: BERGMAN, Kevin, Charlotte, 28202 (US); CSORBA, Paul, Charlotte, 28202 (US); HARRINGTON, James B., Charlotte, 28202 (US)
(74) Representative: Haseltine Lake Kempner LLP

(57) **Abstract**

A system comprising: an inner housing; an electronic device disposed within the inner housing, the electronic device comprising processing circuitry and generator circuitry; an outer housing; and a thermoelectric cooler (TEC) disposed between the inner housing and the outer housing, the TEC comprising: a first surface thermally coupled to the inner housing, and a second surface thermally coupled to the outer housing, wherein the processing circuitry is coupled to the TEC, and is configured to: receive electrical signals; determine the temperature of the inner housing based on the received electrical signals; compare the determined temperature against a threshold temperature; and based on a determination that the determined temperature does not satisfy the threshold temperature, cause the generator circuitry to deliver DC electric current to the TEC to cause the TEC to modulate the temperature of the inner housing.

## Description

### TECHNICAL FIELD

The disclosure relates to temperature control of surfaces and enclosures, specifically surfaces and enclosures used for electronics.

### BACKGROUND

A thermoelectric cooler (TEC), also referred to as a Peltier cooler, is a semiconductor-based electronic component that functions as a solid state heat pump. Direct current (DC) electric current applied to the terminals of the TEC results in a thermal temperature difference. This phenomenon may cause one face of the module to be cooled while an opposite face is heated. Reversing the polarity of the DC current causes the thermal temperature difference to reverse. If different surfaces of the TEC experience a thermal temperature difference, the TEC may experience a DC current. In this manner, a thermoelectric module may be used for both heating and cooling and may be useful for precise temperature sensing and control applications.

### SUMMARY

Some electrical devices may need to be maintained below a threshold temperature, above a threshold temperature, or within a threshold temperature range. A thermal regulation system for an electrical device may need to control the temperature of the electrical device.

This disclosure describes an application of one or more thermoelectric cooler (TEC) module(s) to control and/or sense temperature of electronic components and/or electrical devices. Electrical components and/or devices may be enclosed within an inner housing. A TEC module may be enclosed between the inner housing and an outer housing and may control the temperature of the electrical components and/or electrical devices within the inner housing. Thermodynamic control of the electrical components and/or devices, such as accelerometers, gyroscopes or other sensors, may be beneficial for performance of the electrical components and/or devices, e.g., accurate measurements by the accelerometers, gyroscopes, or the other sensors.

The TEC module may conform to the shape of the inner housing and/or the outer housing to facilitate thermodynamic control of the electrical components and/or devices when the inner housing and/or the outer housing assume curved, angular, or irregular shapes. In some examples, a system senses temperatures of the inner housing and/or the outer housing based on signals from the TEC and controls temperature of the electrical components and/or devices within the inner housing based on the sensed temperatures. The TEC module may include one or more TECs. The one or more TECs may be electrically coupled (e.g., in series, in parallel) and may be actuated individually or in conjunction to control the temperature of the inner housing.

In some examples, this disclosure describes a system comprising: an inner housing; an electronic device disposed within the inner housing, wherein the electronic device comprises one or more of an accelerometer or a gyroscope; an outer housing disposed radially outwards of the inner housing relative to an axis of the inner housing; and a thermoelectric cooler (TEC) disposed between the inner housing and the outer housing, the TEC comprising: a first surface thermally coupled to the inner housing, and a second surface thermally coupled to the outer housing, wherein the TEC is configured to, in response to application of DC electrical current, transfer thermal energy between the TEC and the inner housing and between the TEC and the outer housing to modulate temperature of the electronic device, and wherein the inner housing defines a first geometry, wherein the outer housing defines a second geometry, and wherein the first surface of the TEC is shaped to conform to the first geometry and the second surface of the TEC is shaped to conform to the second geometry.

In some examples, this disclosure describes a system comprising: an inner housing; an electronic device disposed within the inner housing; an outer housing disposed radially outwards of the inner housing relative to an axis of the inner housing; and a thermoelectric cooler (TEC) disposed between the inner housing and the outer housing, the TEC comprising a plurality of semiconductors, each semiconductor comprising: a first surface thermally coupled to the inner housing, and a second surface thermally coupled to the outer housing, wherein the TEC is configured to, in response to application of DC electrical current, transfer thermal energy between the TEC and the inner housing and between the TEC and the outer housing via the plurality of semiconductors to modulate temperature of the electronic device, and wherein one or more of the inner housing or the outer housing comprises a ceramic material, and wherein the plurality of semiconductors of the TEC are in direct contact with the ceramic material.

In some examples, this disclosure describes a system comprising: an inner housing; an electronic device disposed within the inner housing, the electronic device comprising processing circuitry and generator circuitry; an outer housing disposed radially outwards of the inner housing relative to an axis of the inner housing; and a thermoelectric cooler (TEC) disposed between the inner housing and the outer housing, the TEC comprising: a first surface thermally coupled to the inner housing, and a second surface thermally coupled to the outer housing, wherein the processing circuitry is coupled to the TEC, and wherein the processing circuitry is configured to: receive electrical signals corresponding to a temperature of the inner housing; determine the temperature of the inner housing based on the received electrical signals; compare the determined temperature against a threshold temperature; and based on a determination that the determined temperature does not satisfy the threshold temperature, cause the generator circuitry to deliver DC electric current to the TEC to cause the TEC to transfer thermal energy between the TEC and one or more locations of the inner housing and between the TEC and the outer housing to modulate the temperature of the inner housing.

### BRIEF DESCRIPTION OF THE FIGURES

The details of one or more examples are set forth in the accompanying drawings and the description below. Other features, objects, and advantages will be apparent from the description and drawings, and from the claims.
FIG. 1 is a block diagram illustrating an example electrical system, in accordance with this disclosure.
FIG. 2 is a conceptual diagram illustrating a cross-section view of a thermal regulation system of the electrical system of FIG. 1.
FIG. 3 is a conceptual diagram illustrating a thermal electrical cooler (TEC) disposed between an inner housing and an outer housing of the system of FIG. 1.
FIG. 4A is a conceptual diagram illustrating an example TEC of the system of FIG. 1.
FIG. 4B is a conceptual diagram illustrating another example TEC of the system of FIG. 1.
FIG. 5 is a flow chart illustrating an example process of sensing and regulating thermal energy of an electrical system and/or electrical device.

Like reference characters refer to like elements throughout the figures and description.

### DETAILED DESCRIPTION

Various examples discussed herein describe thermal regulation systems for an electrical system. The thermal regulation system may include a thermal electrical cooler (TEC) module. The thermal regulation system may transmit thermal energy into or out of electrical components and/or devices of the electrical system via the TEC module to control the temperature of the electrical system.

For some electrical systems, the electrical devices and/or components constituting the system need to be maintained at a specific temperature or within a specific temperature range to function. One or more electrical components and/or devices may need to be maintained below a maximum temperature, above a minimum temperature, and/or within a temperature range to function. For example, one or more sensors may need to be maintained at a specific temperature or within a specific temperature range to accurately sense signals. Operation of the electrical components and/or devices may generate thermal energy and thermal energy may flow between an environment surrounding the electrical components and/or devices and the electrical components and/or device. A thermal regulation system may be coupled to the electrical components and/or electrical devices and may thermally regulate the electrical components and/or electrical devices.

Electrical components and/or electrical devices may be relatively small in size (e.g., occupying a relatively small volume, surface area, or weight). In such examples, components of the thermal regulation system may need to be small to effectively thermally regulate the electrical components and/or electrical devices without substantially increasing the volume, weight, or surface area occupied by the electrical systems.

As described in this disclosure, a thermal regulation system for an electrical system may include a TEC module configured to regulate the temperature(s) of electrical components and/or electrical devices within the electrical system. The TEC module may include one or more TECs. Each TEC may define a first surface and a second surface. In response to application of Direct Current (DC) electrical current to the TEC module with a specific polarity, each TEC may experience a thermal temperature difference between the first surface and the second surface. For example, in response to receiving DC electrical current with a first polarity, each TEC may experience a temperature difference between the first surface and the second surface, wherein the first surface is at a lower temperature than the second surface. In another example, in response to receiving DC electrical current with a second polarity opposite to the first polarity, the TEC may experience a temperature difference between the first surface and the second surface in an opposite direction, e.g., where the first surface is at a higher temperature than the second surface. Multiple TECs within the TEC module may be electrically coupled, e.g., in parallel. When electrically coupled, TECs of the TEC module may be activated individually or simultaneously to control the temperature of the electrical components and/or devices. For example, one or more TECs of the TEC module may be individually activated to control thermal events in a localized region.

Each TEC may include one or more electrical semiconductors extending from the first surface to the second surface. The one or more electrical semiconductors may transmit DC current between the first surface and the second surface in response to receiving DC current or a DC voltage. The transmission of the DC current may cause a temperature difference between the first surface and the second surface due to the DC current through semiconductors of the TEC. The semiconductors may be in contact with a ceramic material (e.g., a thermoelectric ceramic material) or a compatible metallic alloy at the first surface and at the second surface. The ceramic material or compatible alloy may isolate and/or protect the electrical semiconductors from other components constituting the electrical system (e.g., from a housing of the system). Each TEC may be shaped and/or positioned to conform to the housing of the electrical system and facilitate use of the TEC module in electrical systems with curved, angular, other irregular shapes.

The temperature difference between surfaces of each TEC may facilitate cooling and/or heating of electrical devices/systems. In some examples, TECs may, in response to a DC current of an initial polarity, define a first temperature difference between the surfaces of the TECs (e.g., a first surface of the TEC is at a lower temperature than the second surface of the TEC). In this example, thermal energy may flow from the TECs to an inner housing of an electrical system in a first direction and from the TECs to an outer housing of the electrical system in a second direction different from the first direction (e.g., opposite the first direction). The flow of thermal energy from the TECs to the inner housing and separately from the TECs to the outer housing may facilitate cooling of electrical devices and/or components disposed within the inner housing. In some examples, TECs may, in response to a DC current of a reverse polarity, define a second temperature difference between the surfaces of the TECs. The second temperature difference (e.g., the first surface being at a higher temperature than the second surface) may be different from the first temperature difference. In such examples, thermal energy may flow from the TECs to the inner housing in the second direction and separately from the TECs to the outer housing in the first direction, which may facilitate heating of electrical devices and/or components disposed within the inner housing.

The thermal regulation systems described in this disclosure may provide several benefits over other thermal regulation systems for electrical systems. In some examples, the TEC(s) of a TEC module may be curved and may be disposed and/or positioned within a curved, angular, or irregular housing of an electrical system. Such configurations may allow for an increased applicability of TECs for thermal regulation of electrical devices, e.g., within electrical systems with volume and/or dimension limitations. The thermal regulation system may use the one or more TECs to sense the temperatures of the one or more components in conjunction with controlling the temperature of the electrical components and/or devices, e.g., without requiring separate or additional temperature sensors coupled to the electrical system. In some examples, one or more TECs of the TEC module may be individually activated to regulated temperature of the electrical system within a localized region, allowing the thermal regulation system to address localized fluctuations in temperature within the electrical system without altering the functions of other components (e.g., other TECs of the TEC module) within the thermal regulation system.

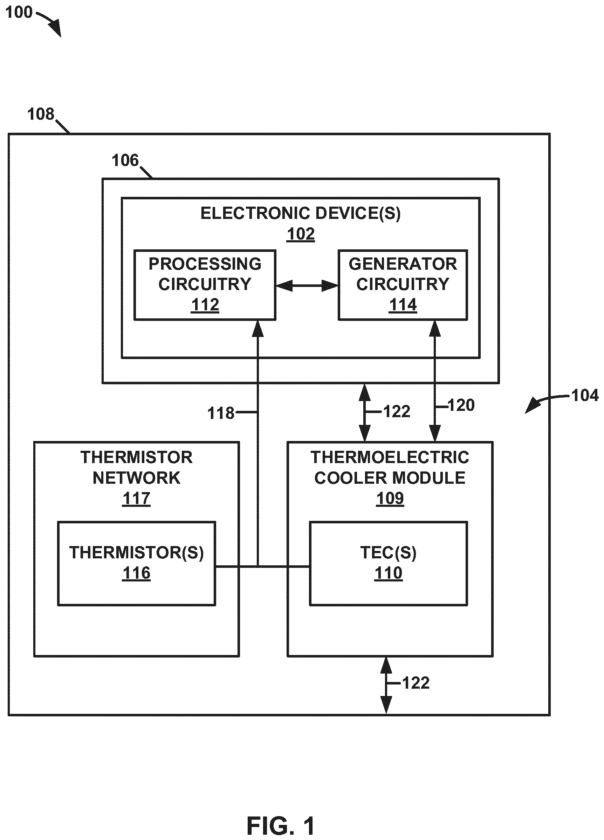

FIG. 1 is a block diagram illustrating an example electrical system 100 (also referred to herein as "system 100"), in accordance with this disclosure. System 100 may include one or more electronic device(s) 102 disposed within an inner housing 106. System 100 may further include an outer housing 108 disposed radially outwards of and enclosing inner housing 106. System 100 may include a thermal regulation system 104 disposed within outer housing 108. Thermal regulation system 104 may be configured to regulate the temperatures of electronic device(s) 102 within inner housing 106.

Electronic device(s) 102 may include one or more electronic components or devices configured to perform one or more functions. Electronic device(s) 102 may include, but are not limited to, sensor(s), proof mass(es), communications circuitry, sensing circuitry, or other computing circuitry or electronic components. Sensors may include accelerometers (e.g., resonating beam accelerometers (RBA), gyroscopes (e.g., fiberoptic gyroscopes), or other sensors configured to sense movement of system 100. In some examples, the type and functionality of electronic device(s) would require inner housing 106 to define different dimensions and/or different shapes (e.g., rectangular shapes, cylindrical shapes, spherical shapes, prismatic shapes, irregular shapes).

Thermal regulation system 104 may include a thermoelectric cooler (TEC) module 109, processing circuitry 112, generator circuitry 114, and thermistor(s) 116. TEC module 109 may include one or more TECs 110. TEC(s) 110 may be thermally coupled to inner housing 106 and to outer housing 108. For example, a first surface of TEC(s) 110 may be thermally coupled to inner housing 106 and a second surface of TEC(s) 110 may be thermally coupled to outer housing 108.

In some examples, one or more thermistor(s) 116 may form a thermistor network 117. Processing circuitry 112 may receive electrical signals 118 from TEC(s) 110 and/or thermistor(s) 116 and may determine temperatures of inner housing 106 and/or outer housing 108 based on electrical signals 118. For example, processing circuitry 112 may determine temperatures based on voltage differentials between surfaces of TEC(s) 110 based on sensed electrical signals 118 and/or from thermistor(s) 116 thermally coupled to inner housing 106 and/or outer housing 108. Processing circuitry 112 may then determine whether the temperatures satisfy a threshold condition (e.g., whether the temperatures are above a minimum threshold temperature, are below a maximum threshold temperature, or are within a threshold temperature range). In response to a determination that the temperatures do not satisfy a threshold condition, processing circuitry 112 may transmit instructions to generator circuitry 114 to cause generator circuitry 114 to deliver DC electrical current 120 to TEC module 109, which causes TEC(s) 110 to transfer thermal energy 122 (e.g., positive thermal energy, negative thermal energy) to inner housing 106 and/or outer housing 108. "Positive thermal energy" may refer to the flow of thermal energy from one element (e.g., TEC(s) 110) into another element (e.g., inner housing 106, outer housing 108) in a specified direction (e.g., from TEC(s) 110 into inner housing 106). "Negative thermal energy" may refer to the flow of thermal energy from one element (e.g., TEC(s) 110) into another element (e.g., inner housing 106, outer housing 108) in a direction opposite the specified direction.

Flow of thermal energy 122 may be reversed with a reversed polarity of DC electric current 120. In some examples, positive thermal energy 122 flows from TEC(s) 110 into inner housing 106 and negative thermal energy 122 flows from TEC(s) 110 into outer housing 108 when induced with a first polarity (e.g., by DC electric current 120). This flow of energy may heat electronic devices inside inner housing 106. In another example, negative thermal energy 122 flows from TEC(s) 110 into inner housing 106 and positive thermal energy 122 flows from TEC(s) 110 into outer housing 108 when induced with a second polarity different from the first polarity (e.g., by DC electric current 120). This flow of energy may cool the electronic devices inside inner housing 106.

When TEC(s) 110 receive DC electrical current 120 from generator circuitry 114, DC electrical current 120 may produce a temperature difference between surfaces of TEC(s) 110 via a Peltier-Seebeck effect. A polarity of DC electrical current 120 received by TEC(s) 110 may control the temperature difference. For example, TEC(s) 110 may, in response to DC electrical current 120, be induced with a first polarity (also referred to herein as an "initial polarity"), which causes a first temperature difference wherein a first surface coupled to inner housing 106 is at a lower temperature than a second surface coupled to outer housing 108. This first temperature difference may facilitate transfer of negative thermal energy 122 from TEC(s) 110 into inner housing 106 and of positive thermal energy 122 from TEC(s) 110 into outer housing 108, thereby cooling electronic device(s) 102. In another example, TEC(s) 110 may, in response to DC electrical current 120, be induced with a second polarity (also referred to herein as a "reverse polarity") different form the initial polarity, which causes a second temperature difference wherein the temperature of second surface is lower than the temperature of the first surface. The second temperature difference may facilitate transfer of negative thermal energy 122 from TEC(s) 110 into outer housing 108 and of positive thermal energy 122 from TEC(s) 110 into inner housing 106, thereby heating electronic device(s) 102. Processing circuitry 112 may cause generator circuitry 114 to deliver DC electrical current 120 with different polarities based on the sensed temperatures, e.g., to heat or cool electronic device(s) 102 within inner housing 106.

Processing circuitry 112 and generator circuitry 114 may be disposed within inner housing 106. In some examples, as illustrated in FIG. 1, processing circuitry 112 and generator circuitry 114 are components of or are electrically connected or coupled to electronic device(s) 102. For example, processing circuitry 112 may share common computing and/or processing components (e.g., a common circuit board) as electronic device(s) 102. In such examples, thermal regulation system 104 may be controlled by one or more electronic device(s) 102 of system 100. In some examples, processing circuitry 112 and generator circuitry 114 are physically and/or electrically separated from electronic device(s) 102 and outside of inner housing 106. In such examples, thermal regulation system 104 may operate independently of electronic device(s) 102 of system 100.

System 100 as described herein may be used in a plurality of applications. Example applications include, but are not limited to, use in a satellite, a vehicle (e.g., an automobile, an aircraft, an unmanned aerial vehicle (UAV), a watercraft), and/or functions requiring extended periods of time between inspections of system 100.

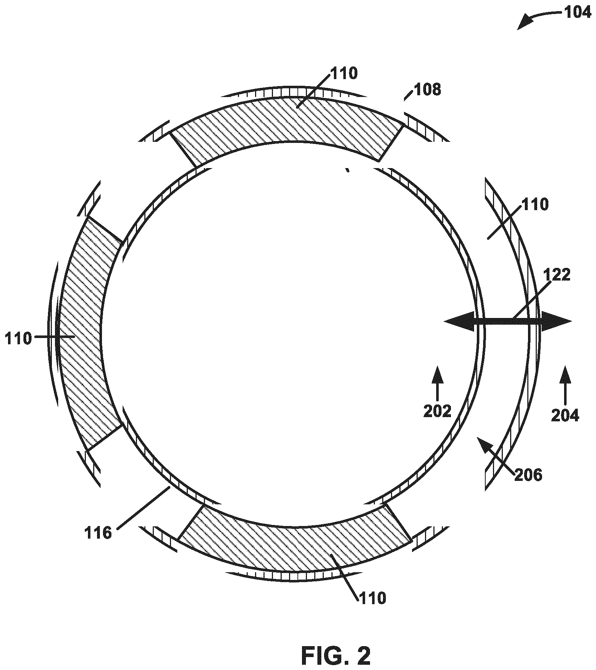

FIG. 2 is a conceptual diagram illustrating a cross-sectional view of an example of thermal regulation system 104 of system 100 of FIG. 1. While FIG. 2 illustrates inner housing 106 and outer housing 108 of system 100 as defining a cylindrical shape, other examples of system 100 may including inner housing 106 and/or outer housing 108 defining other shapes including, but are not limited to, a spherical shape, a torus shape, a rectangular-prism shape, other prism shapes, or irregular shapes. Inner housing 106 and/or outer housing 108 may define different shapes based on constraints on dimensions, weight, volume, and/or surface area of system 100 and/or based on the dimensions of electronic device(s) 102 disposed within inner housing 106.

Inner housing 106 may define an inner volume 202 configured to retain electronic device(s) 102 and/or components of thermal regulation system 104 (e.g., processing circuitry 112, generator circuitry 114). Inner housing 106 may isolate electronic device(s) 102 from external interference, e.g., from external electromagnetic radiation, from electrostatic discharge (ESD). Inner housing 106 may also shield TEC(s) 110 from interference from electronic device(s) 102 (e.g., electromagnetic radiation, ESD from electronic device(s) 102). TEC(s) 110 may further shield electronic device(s) 102 from external interference (e.g., electromagnetic radiation, ESD). Inner housing 106 may be thermally coupled to electronic device(s) 102 and to TEC(s) 110. Thermal energy 122 may enter or exit electronic device(s) 102 along a path extending through inner housing 106.

Outer housing 108 may be disposed radially outside of inner housing 106, e.g., relative to an axis of system 100. Inner housing 106 and outer housing 108 may be separated by space 206. Outer housing 108 may isolate (e.g., physically, electrically) system 100 and thermal regulation system 104 from external environment 204. For example, outer housing 108 may isolate TEC(s) 110 and/or electronic devices 102 from external electromagnetic radiation and/or external ESD. Outer housing 108 may be thermally coupled to TEC(s) 110.

Thermal regulation system 104 may transfer thermal energy 122 between inner volume 202 and TEC(s) 110 and separately between TEC(s) 110 and environment 204, e.g., to heat or cool electronic device(s) 102. TEC(s) 110 may be electrically coupled to processing circuitry 112 and generator circuitry 114 within volume 202, e.g., via one or more electrical wires extending from volume 202 to space 206 through inner housing 106. In some examples, processing circuitry 112 and generator circuitry 114 are disposed within space 206.

As illustrated in FIG. 2, TEC(s) 110 may be disposed within space 206 and may be thermally coupled to inner housing 106 and to outer housing 108. TEC(s) 110 may be equally distributed around a circumference and/or a length of an axis of inner housing 106, e.g., to equally cool or heat inner housing 106. In some examples, two or more TEC(s) 110 may be concentrated around a specific or localized region around the circumference and/or along the length of an axis of inner housing 106, e.g., to increase temperature control at a specific or localized region of inner housing 106. For example, depending on the placement of electronic device(s) 102 within inner volume 202, specific or localized regions of inner housing 106 may experience increased localized changes in temperature compared to other regions of inner volume 202. Two or more TEC(s) 110 may be concentrated around the specific regions to increase temperature control at the specific or localized regions.

In some examples, as illustrated in FIG. 2, thermal regulation system 104 may include one or more thermistors 116 of thermistor network 117 disposed within space 206. Thermistor network 117 may include one or more thermistor(s) 116 coupled to one or more thermistor bands. Thermistor(s) 116 may sense temperatures of inner housing 106 and/or of outer housing 108 at one or more locations. Thermistor(s) 116 may transmit electrical signals indicating the sensed temperatures to processing circuitry 112. In some examples, thermal regulation system 104 does not include thermistor(s) 116 and TEC(s) 110 within TEC module 109 is configured to sense and control temperatures of inner housing 106 and/or outer housing 108.

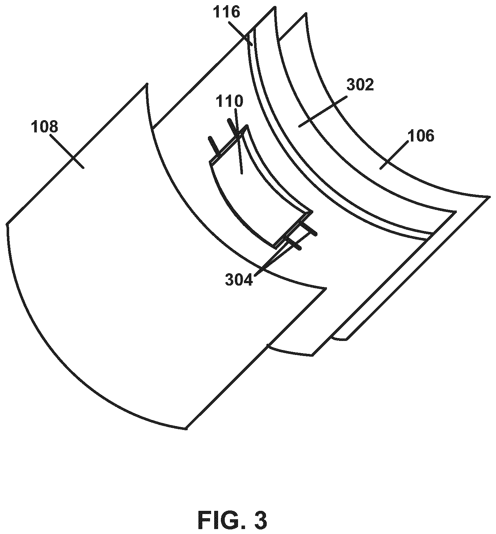

FIG. 3 is a conceptual diagram illustrating a TEC 110 disposed between inner housing 106 and outer housing 108 of the system of FIG. 1. In some examples, as illustrated in FIG. 3, inner housing 106 is thermally coupled to a temperature moderation element 302 (e.g., a heating element, a cooling element) and TEC(s) 110 and thermistor(s) 116 are disposed on temperature moderation element 302. In some examples, TEC(s) 110 and thermistor(s) 116 are disposed directly on inner housing 106. In some examples, TEC(s) 110 may be integrated into TEC module 109 and thermistor(s) 116 may be integrated into thermistor network 117.

Temperature moderation element 302 may be formed from a thermally conductive material. Temperature moderation element 302 may distribute heating and cooling effects of TEC(s) 110 across inner housing 106, e.g., to heat and cool inner housing 106 and electronic device(s) 102, respectively. Temperature moderation element 302 may retain TEC(s) 110 of TEC module 109 and/or thermistor(s) 116 of thermistor network 117 as a single component, e.g., to facilitate assembly of system 100. For example, a manufacturing system may affix temperature moderation element 302 around inner housing 106 and then dispose outer housing 108 radially outwards of inner housing 106 and temperature moderation element 302. Temperature moderation element 302 may be flexible, semi-flexible, or rigid. Temperature moderation element 302 may be sized and shaped to conform to the size and shape (e.g., the curvature or irregular geometry) of inner housing 106.

TEC(s) 110 of TEC module 109 may be disposed between inner housing 106 and outer housing 108, e.g., on inner housing 106, on temperature moderation element 302. TEC(s) 110 may be in contact with or otherwise thermally coupled to inner housing 106 and to outer housing 108. In some examples, as illustrated in FIG. 3, inner housing 106 and/or outer housing 108 may define a geometry (e.g., curvature, irregular geometry) across at least a portion of inner housing 106 and/or outer housing 108. For example, inner housing 106 and/or outer housing 108 may define an O-shape, a D-shape, a U-shape, a C-shape, or the like. In some examples, inner housing 106 and/or outer housing 108 may define angular, irregular, geometrical shapes across at least a portion of inner housing 106 and/or outer housing 108. Inner housing 106 and outer housing 108 may define a same, similar, or different shapes. TEC(s) 110 may be shaped to conform to the geometry of one or more of inner housing 106 or outer housing 108. In some examples, multiple TECs 110 are electrically coupled such that TEC module 109 including the multiple TECs 110 define a shape configured to conform to one or more of inner housing 106 and/or outer housing 108.

TEC(s) 110 may be coupled to generator circuitry 114 disposed within inner housing 106 via one or more electrically conductive contacts 304. Contacts(s) 304 may extend through temperature moderation element 302 and/or inner housing 106 and may link TEC(s) 110 with generator circuitry 114 in an electrical circuit. TEC(s) 110 may receive DC electrical current 120 from generator circuitry 114 via contact(s) 304.

In some examples, TEC module 109 includes two or more TEC(s) 110. Each TEC 110 may be separated and electrically coupled to generator circuitry 114, e.g., via separate contacts 304. In some examples, two or more TECs 110 may be electrically coupled (e.g., in series) and may be electrically connected via contacts 304. In such examples, DC electrical current 120 flows from generator circuitry 114 into a first TEC 110 via contacts 304. DC electrical current 120 may then flow across the electrically coupled TECs 110 and then flow from a second TEC 110 back into generator circuitry 114 to complete the electrical circuit. In some examples, two or more TECs 110 may be electrically coupled in parallel.

Generator circuitry 114 may transmit DC electrical current 120 to specific contacts 304 to selectively activate individual TECs 110 (e.g., to locally moderate temperature of inner housing 106) or to activate multiple TECs 110 (e.g., to moderate the temperature of inner housing 106 across an entire surface area of inner housing 106).

In some examples, thermal regulation system 104 may sense temperatures of inner housing 106 and/or of outer housing 108 based on electrical signals from TEC(s) 110. In such examples, TEC(s) 110 may be electrically coupled to processing circuitry 112 via contact(s) 304. In such examples, contact(s) 304 may be coupled to one or more surfaces of TEC(s) 110. For example, contact(s) 304 may couple processing circuitry 112 to first surface(s) of TEC(s) 110 thermally coupled to inner housing 106 and to second surface(s) of TEC(s) 110 thermally coupled to outer housing 108.

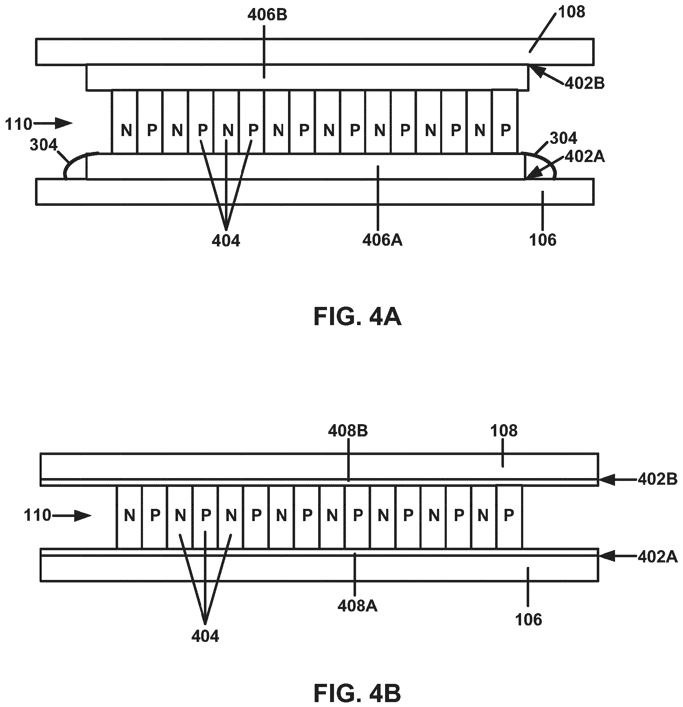

FIG. 4A is a conceptual diagram illustrating an example TEC 110 of system 100 of FIG. 1. TEC 110 may be disposed between and may be thermally coupled to inner housing 106 and outer housing 108. TEC 110 may define a plurality of surfaces 402A, 402B (collectively referred to herein as "surfaces 402"). TEC 110 may include a plurality of conducting plates 406A, 406B (collectively referred to herein as "conducting plates 406") defining surfaces and a plurality of semiconductors 404 extending between conducting plates 406. While FIG. 4A is described within reference to TEC 110 with a plurality of semiconductors 404, other example TECs 110 may include an identical structure to the example TEC 110 illustrated in FIG. 4A with semiconductors arranged in the same configurations described below. While FIG. 4A illustrates a single-stage TEC 110, other example TECs 110 described herein may include two or more stages.

A first surface 402A of TEC 110 may be placed in contact with or otherwise thermally coupled to inner housing 106. For example, a first conducting plate 406A defining first surface 402A may be affixed to and/or in contact with inner housing 106. A second surface 402B of TEC 110 may be placed in contact with or otherwise thermally coupled to outer housing 108. For example, a second conducting plate 406B defining second surface 402B may be affixed to and/or in contact with outer housing 108. TEC 110 may facilitate transference of thermal energy 122 between inner housing 106 and first surface 402A and between outer housing 108 and second surface 402B, e.g., in response to DC electrical current 120. In such examples, DC electrical current 120 creates a temperature difference between first surface 402A and second surface 402B, which facilitates the transference of thermal energy 122 out of TEC 110.

Conducting plates 406 may include a thermally conductive material that may electrically isolate semiconductors 404 from inner housing 106. When TEC 110 is in contact with both inner housing 106 and outer housing 108, conducting plates 406 may electrically isolate inner housing 106 and outer housing 108. The thermally conductive material may include, but is not limited to, a ceramic material. Example ceramic materials include aluminum oxide ceramics, aluminum nitride ceramics, beryllium oxide ceramics, or the like. Conducting plates 406 may be maintained at different temperatures corresponding to the different housings coupled to conducting plates 406. For example, first conducting plate 406A and inner housing 106 may be at first temperature and second conducting plate 406B and outer housing 108 may be at a second temperature different from the first temperature. In some examples, in response to receiving DC current 120 of an initial polarity, first conducting plate 406A may be at a higher temperature than second conducting plate 406B. In some examples, in response to receiving DC current 120 of a reversed polarity, first conducting plate 406A may be at a lower temperature than second conducting plate 406B. Conducting plates 406 may be permanently or removably affixed to inner housing 106 and outer housing 108. Conducting plates 406 may be affixed to inner housing 106 and outer housing 108 via one or more of an adhesive, a fixation feature (e.g., a screw, a bolt, a washer), or the like.

A plurality of semiconductors 404 extend between and connect conducting plates 406. In some examples, semiconductors 404 may be arranged in pairs, each pair of semiconductors 404 forming a thermoelectric couple of semiconductors 404 that are electrically connected in series and thermally connected in parallel. In some examples, pairs of conductors 404 may be electrically connected in parallel. Each pair of semiconductors 404 may include one N-type conductor ("N") and one P-type conductor ("P"). Pairs of semiconductors 404 may be electrically connected in series and thermally connected in parallel to form a matrix of semiconductors 404 spanning the space between conducting plates 406. A number of semiconductors 404 and/or a contact area between semiconductors 404 and conducting plates 406 may determine a cooling/heating rate of TEC 110. Increasing a number of semiconductors 404 and/or a contact area between semiconductors 404 and conducting plates 406 may increase a cooling and/or heating rate of TEC 110.

When thermal regulation system 104 delivers DC electrical current 120 from generator circuitry 114 to semiconductors 404 via contacts 304, DC electric current 120 may flow between first surface 402A and second surface 402B in one direction along a first semiconductor 404 of each pair of semiconductors 404 and in an opposite direction along a second semiconductor 404 of each pair of semiconductors 404. For example, DC electric current 120 may flow from first surface 402A towards a second surface 402B along a P-type conductor and from second surface 402B towards first surface 402A along an N-type conductor, or vice versa. Flow of DC electric current 120 along semiconductors 404 in this manner may create a difference in voltage between first surface 402A and second surface 402B. The voltage difference may lead to a temperature difference between first surface 402A and second surface 402B, e.g., wherein the first surface 402A is at a higher temperature than second surface 402B, or vice versa.

Thermal regulation system 104 may change the polarity of DC electric current 120 to heat or cool inner housing 106. When thermal regulation system 104 transmits DC electric current 120 with a first polarity (e.g., an initial polarity) to TEC 110, the flow of DC electric current 120 through semiconductors 404 may lead to a transference of negative thermal energy 122 from TEC 110 (e.g., from conducting plate 406A of TEC 110) into inner housing 106 (e.g., alternatively referred to as transference of positive thermal energy 122 from inner housing 106 into TEC 110) in conjunction with a transference of positive thermal energy 122 from TEC 110 (e.g., from conducting plate 406B of TEC 110) into outer housing 108. For example, DC electric current 120 of an initial polarity may create a temperature difference between conducting plates 406, which may create a temperature difference between inner housing 106 and conducting plate 406A. The temperature difference between inner housing 106 and conducting plate 406A may lead to a transference of negative thermal energy 122 from conducting plate 406A into inner housing 106 (e.g., into electronic device(s) 102 within inner housing 106) through conduction. When DC electric current 120 travels along semiconductors 404 from conducting plate 406A to conducting plate 406B, there is a change in temperature at a junction between two semiconductors 404 (e.g., at or around surfaces 402). This temperature difference may be multiplied by the multiple junctions formed by semiconductors 404 between conducting plates 406, thereby forming a thermal temperature difference between conducting plate 406A and conducting plate 406B. There may be a temperature difference between conducting plate 406B and outer housing 108 (e.g., the temperature of conducting plate 406B is higher than the temperature of outer housing 108), which may lead to flow of positive thermal energy 122 from conducting plate 406B into outer housing 108.

When thermal regulation system 104 transmit DC electric current 120 with a reversed polarity opposite to the first polarity to TEC 110, DC current electric current 120 may create a thermal temperature difference between conducting plate 406A and conducting plate 406B in an opposite direction as DC electric current 120 with the first polarity. In such examples, negative thermal energy 122 may flow from TEC 110 (e.g., from conducting plate 406B) into outer housing 108 and positive thermal energy 122 may flow from TEC 110 (e.g., from conducting plate 406A) into inner housing 106, thereby heating inner housing 106.

FIG. 4B is a conceptual diagram illustrating another example TEC 110 of system 100 of FIG. 1. In some examples, one or more of inner housing 106 or outer housing 108 may include a conductive material defining thermally conductive interfaces 408A, 408B (collective referred to as "interfaces 408") at surfaces 402. Interfaces 408 may thermally connect and electrically isolate semiconductors 404 of TEC 110 with inner housing 106 and/or outer housing 108.

Interfaces 408 may be formed from a thermally conductive material. The thermally conductive material may electrically isolate semiconductors 404 from inner housing 106 and/or outer housing 108. The thermally conductive material may include, but is not limited to, a ceramic material. Example ceramic materials include aluminum oxide ceramics, aluminum nitride ceramics, beryllium oxide ceramics, or the like. In some examples, inner housing 106 and/or outer housing 108 are formed partially or entirely of the thermally conductive material. In some examples, interfaces 408 may include a coating or a layer of the thermally conductive material disposed between inner housing 106 and/or outer housing 108 and semiconductors 404. In some examples, interfaces 408 may include an adhesive including a thermally conductive material. The adhesive may directly affix semiconductors 404 to inner housing 106 and/or outer housing 108, e.g., without requiring conducting plates 406.

In some examples, system 100 comprises: an inner housing 106; an electronic device 102 disposed within the inner housing, wherein electronic device 102 comprises one or more of an accelerometer or a gyroscope; an outer housing 108 disposed radially outwards of inner housing 106 relative to an axis; and a thermoelectric cooler (TEC) 110 disposed between inner housing 106 and outer housing 108, TEC 110 comprising: a first surface 402A thermally coupled to inner housing 106, and a second surface 402B thermally coupled to outer housing 108, wherein TEC 110 is configured to, in response to application of DC electrical current 120, modulate temperature of the electronic device 102, and wherein inner housing 106 defines a first curvature, wherein outer housing 108 defines a second curvature, and wherein first surface 402A of TEC 110 is shaped to conform to the first curvature and second surface 402B of TEC 110 is shaped to conform to the second curvature.

In some examples, system 100 comprises: an inner housing 106; an electronic device 102 disposed within inner housing 106; an outer housing 108 disposed radially outwards of inner housing 106 relative to an axis; and a thermoelectric cooler (TEC) 110 disposed between inner housing 106 and outer housing 108, TEC 110 comprising a plurality of semiconductors 404, each conductor 404 comprising: a first end (e.g., at surface 402A) thermally coupled to inner housing 106, and a second end (e.g., at surface 402B) thermally coupled to outer housing 108, wherein TEC 110 is configured to, in response to application of DC electrical current 120, modulate temperature of electronic device 102, and wherein one or more of inner housing 106 or outer housing 108 comprises a ceramic material, and wherein the plurality of semiconductors 404 of TEC 110 are in direct contact with the ceramic material.

In some examples, system 100 comprises: an inner housing 106; an electronic device 102 disposed within inner housing 106, electronic device 102 comprising processing circuitry 112 and generator circuitry 114; an outer housing 108 disposed radially outwards of inner housing 106 relative to an axis; and a thermoelectric cooler (TEC) 110 disposed between inner housing 106 and outer housing 108, TEC 110 comprising: a first surface 402A thermally coupled to inner housing 106, and a second surface 402B thermally coupled to outer housing 108, wherein processing circuitry 112 is coupled to TEC 110, and wherein processing circuitry 112 is configured to: receive electrical signals 118 corresponding to a temperature of inner housing 106; determine the temperature of inner housing 106 based on received electrical signals 118; compare the determined temperature against a threshold temperature; and based on a determination that the determined temperature does not satisfy the threshold temperature, cause generator circuitry 114 to deliver DC electric current 120 to TEC 110 to cause TEC 110 to transfer thermal energy 122 between inner housing 106 and TEC 110 and between TEC 110 and outer housing 108 to modulate the temperature of inner housing 106.

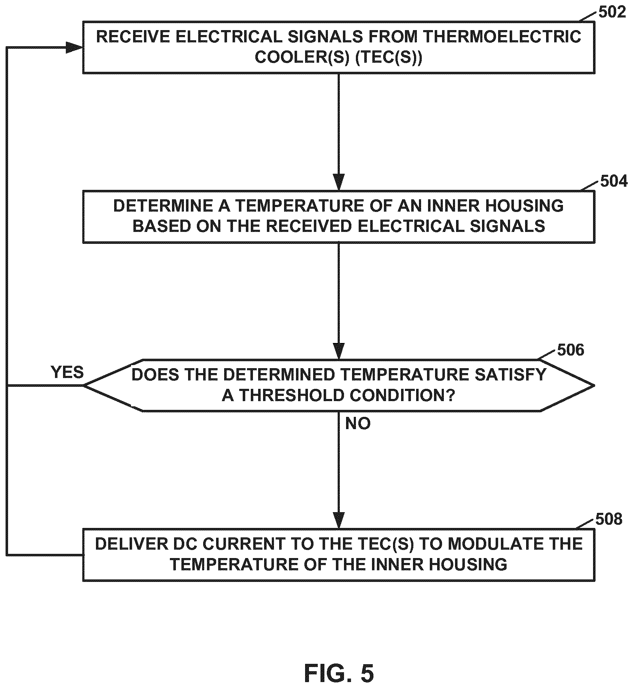

FIG. 5 is a flow chart illustrating an example process of controlling temperature of an electrical system 100. While FIG. 5 is primarily described with respect to sensing temperatures of system 100 via one or more TECs (e.g., TEC(s) 110) within TEC module 109, the process may be performed by sensing temperatures of system 100 via one or more other sensors (e.g., thermistors(s) 116 of thermistor network 117).

Thermal regulation system 104 may receive electrical signals 118 from TEC(s) 110 (502). TEC(s) 110 may be disposed within TEC module 109. Electrical signals 118 may indicate voltage values of semiconductors 404 of TEC(s) 110 at surfaces 402. When TEC(s) 110 experience temperature differentials at surfaces 402, the temperature differentials may cause semiconductors 404 to generate a difference in electric potential, voltage difference, or current difference between the ends of semiconductors 404, i.e., via the Peltier-Seebeck effect. TEC(s) 110 may be coupled to processing circuitry 112 via contact(s) 304. Processing circuitry 112 may be disposed within volume 202 enclosed by inner housing 106 or may be disposed between inner housing 106 and outer housing 108. Contact(s) 304 may extend from TEC(s) 110 within space 206 and into volume 202. Contact(s) 304 may extend from space 206 into volume 202 through one or more openings and/or ports within inner housing 106. In some examples, contact(s) 304 are electrically coupled between first surface 402A and inner housing 106 without requiring any openings and/or ports within inner housing 106. Electrical signals 118 may be transmitted from TEC(s) 110 to processing circuitry 112 via contact(s) 304.

Thermal regulation system 104 may determine a temperature of inner housing 106 based on the received electrical signals 118 (504). Processing circuitry 112 may determine, based on electrical signals 118, a temperature difference between first surface 402A and second surface 402B of TEC(s) 110. Processing circuitry 112 may determine the temperature of inner housing 106 based on the temperature difference between surfaces 402 of TEC(s) 110. For example, processing circuitry 112 may determine the temperature of inner housing 106 based on a temperature of environment 204 and the temperature difference between surfaces 402. In some examples, where environment 204 and/or outer housing 108 are maintained at a uniform temperature, processing circuitry 112 may determine the temperature of inner housing 106 based on the temperature difference between surfaces 402 and the temperature of outer housing 108.

Thermal regulation system 104 may determine whether the determined temperature satisfies a threshold condition (506). Thermal regulation system 104 stores or may store one or more threshold conditions (e.g., threshold temperature range, minimum threshold temperature, maximum threshold temperature) within memory of thermal regulation system 104. In some examples, processing circuitry 112 determines whether the temperature of inner housing 106 is within the threshold temperature range. In some examples, processing circuitry 112 determines whether the temperature of inner housing 106 is greater than or equal to the minimum threshold temperature. In some examples, processing circuitry 112 determines whether the temperature of inner housing 106 is less than or equal to the maximum threshold temperature. The threshold conditions may depend on environment 204 and/or components of electronic device(s) 102 within inner housing 106 (e.g., thermal energy output of components of electronic device(s) 102.

Based on a determination that the determined temperature satisfies a threshold condition ("YES" branch of 506,), thermal regulation system 104 may continue to receive electrical signals 118 from TEC(s) 110 (e.g., TEC(s) 110 within TEC module 109) (502). Based on a determination that the temperature does not satisfy any threshold conditions ("NO" branch of 506), Thermal regulation system 104 may deliver DC electrical current 120 to TEC(s) 110 to modulate the temperature of inner housing (508).

Processing circuitry 112 may cause generator circuitry 114 to generate DC electrical current 120 and transmit DC electrical current 120 to TEC(s) 110 via contact(s) 304. In response to receiving DC electrical current 120, semiconductors 404 of TEC(s) 110 may form a voltage potential difference between surfaces 402, which may cause a temperature differential between surfaces 402. The temperature difference may cause positive or negative thermal energy 122 to flow from TEC(s) 110 into inner housing 106 and an opposite thermal energy 122 to flow from TEC(s) 110 into outer housing 108, thereby modulating the temperature of inner housing 106. Processing circuitry 112 may cause generator circuitry 114 to generate DC electrical current 120 with a specific polarity based on a determination by processing circuitry 112, e.g., to heat or cool inner housing 106. DC electrical current 120 with different polarities may change the direction of the temperature difference and cause TEC(s) 110 to heat or cool inner housing 106. In some examples, DC electrical current 120 with an initial polarity may cause first surface 408A to be at a lower temperature than second surface 408B, which may lead to the flow of negative thermal energy 122 from first surface 408A of TEC(s) 110 into inner housing 106 and the flow of positive thermal energy 122 from second surface 408B into outer housing 108, thereby cooling inner housing 106. In some examples, DC electrical current 120 with a reversed polarity different from the initial polarity may cause first surface 408A to be at a higher temperature than second surface 408B, which may lead to the flow of negative thermal energy 122 from second surface 408B into outer housing 108 and the flow of positive thermal energy 122 from first surface 408A into inner housing 106, e.g., thereby heating inner housing 106.

Thermal regulation system 104 may continue to receive electrical signals 118 from TEC(s) 110 (502). Thermal regulation system 104 may continue to monitor the temperature of inner housing 106 while delivering DC electrical current 120 to TEC(s) 110 until thermal regulation system 104 (e.g., processing circuitry 112) determines that the current temperature of inner housing 106 satisfies a threshold condition, at which point thermal regulation system 104 terminates delivery of DC electrical current 120. Thermal regulation system 104 may continue to receive and monitor electrical signals 118 from TEC(s) 110 and may adjust the temperature of inner housing 106, as described above, to maintain the temperature of inner housing 106 below a maximum threshold temperature, above a minimum threshold temperature, and/or within a threshold temperature range.

In some examples, where multiple TECs 110 are disposed between inner housing 106 and outer housing 108, thermal regulation system 104 may receive and monitor electrical signals 118 from each TEC 110 separately and/or individually. Thermal regulation system 104 may determine, based on electrical signals 118 from multiple TECs 110, localized increases or decreases in temperatures at or around one or more TECs 110 at or around inner housing 106 and/or outer housing 108. Thermal regulation system 104 may deliver DC electrical current 120 to selected TECs 110 within TEC module 109 to control the localized increases or decreases in temperature.

The following examples may illustrate one or more of the techniques of this disclosure.

Example 1: a system comprising: an inner housing; an electronic device disposed within the inner housing, wherein the electronic device comprises one or more of an accelerometer or a gyroscope; an outer housing disposed radially outwards of the inner housing relative to an axis of the inner housing; and a thermoelectric cooler (TEC) disposed between the inner housing and the outer housing, the TEC comprising: a first surface thermally coupled to the inner housing, and a second surface thermally coupled to the outer housing, wherein the TEC is configured to, in response to application of DC electrical current, transfer thermal energy between the TEC and the inner housing and between the TEC and the outer housing to modulate temperature of the electronic device, and wherein the inner housing defines a first geometry, wherein the outer housing defines a second geometry, and wherein the first surface of the TEC is shaped to conform to the first geometry and the second surface of the TEC is shaped to conform to the second geometry.

Example 2: the system of example 1, wherein the TEC is configured to: in response to the application of DC electrical current with an initial polarity, transfer a negative thermal energy from the TEC to the inner housing and a positive thermal energy from the TEC to the outer housing, and in response to the application of DC electrical current with a reversed polarity, transfer a positive thermal energy from the TEC to the outer housing and a negative thermal energy from the TEC to the inner housing, wherein the initial polarity is different from the reversed polarity.

Example 3: the system of any of examples 1 or 2, wherein the first geometry is different from the second geometry.

Example 4: the system of any of examples 1-3, wherein the electronic device comprises: generator circuitry electrically coupled to the TEC and configured to deliver the DC electrical current to the TEC; and processing circuitry electrically coupled to the generator circuitry and to the TEC, the processing circuitry being configured to: receive electrical signals from the TEC; determine, based on the electrical signals, a temperature value sensed by the TEC; compare the temperature value of the TEC against a threshold temperature value; and in response to a determination that the temperature value of the TEC does not satisfy the threshold temperature value, cause the generator circuitry to deliver the DC electrical current to the TEC.

Example 5: the system of example 4, wherein the electrical signals from the TEC indicates a first voltage potential at the first surface and a second voltage potential at the second surface, and wherein to determine the temperature value sensed by the TEC, the processing circuitry is configured to: determine, based on the first voltage potential and the second voltage potential, a voltage potential difference between the first surface and the second surface of the TEC; and determine, based on the voltage potential difference, one or more of: a temperature difference between the inner housing and the outer housing, a first temperature of the inner housing, or a second temperature of the outer housing.

Example 6: the system of any of examples 1-5, wherein the outer housing is configured to shield the electronic device and the TEC from one or more of electromagnetic radiation or electrostatic discharge (ESD).

Example 7: the system of any of examples 1-6, wherein the electronic device comprises a resonating beam accelerometer.

Example 8: a system comprising: an inner housing; an electronic device disposed within the inner housing; an outer housing disposed radially outwards of the inner housing relative to an axis of the inner housing; and a thermoelectric cooler (TEC) disposed between the inner housing and the outer housing, the TEC comprising a plurality of semiconductors, each semiconductor comprising: a first surface thermally coupled to the inner housing, and a second surface thermally coupled to the outer housing, wherein the TEC is configured to, in response to application of DC electrical current, transfer thermal energy between the TEC and the inner housing and between the TEC and the outer housing via the plurality of semiconductors to modulate temperature of the electronic device, and wherein one or more of the inner housing or the outer housing comprises a ceramic material, and wherein the plurality of semiconductors of the TEC are in direct contact with the ceramic material.

Example 9: the system of example 8, wherein the ceramic material comprises a ceramic coating disposed over the one or more of the inner housing or the outer housing.

Example 10: the system of any of examples 8 or 9, wherein the ceramic material comprises a ceramic-type adhesive disposed over the one or more of the inner housing or the outer housing, and wherein the plurality of semiconductors of the TEC are affixed to the one or more of the inner housing or the outer housing via the ceramic-type adhesive.

Example 11: the system of any of examples 8-10, wherein the inner housing defines a first geometry, wherein the outer housing defines a second geometry, and wherein the TEC is shaped to conform to the first geometry and to the second geometry.

Example 12: a system comprising: an inner housing; an electronic device disposed within the inner housing, the electronic device comprising processing circuitry and generator circuitry; an outer housing disposed radially outwards of the inner housing relative to an axis of the inner housing; and a thermoelectric cooler (TEC) disposed between the inner housing and the outer housing, the TEC comprising: a first surface thermally coupled to the inner housing, and a second surface thermally coupled to the outer housing, wherein the processing circuitry is coupled to the TEC, and wherein the processing circuitry is configured to: receive electrical signals corresponding to a temperature of the inner housing; determine the temperature of the inner housing based on the received electrical signals; compare the determined temperature against a threshold temperature; and based on a determination that the determined temperature does not satisfy the threshold temperature, cause the generator circuitry to deliver DC electric current to the TEC to cause the TEC to transfer thermal energy between the TEC and one or more locations of the inner housing and between the TEC and the outer housing to modulate the temperature of the inner housing.

Example 13: the system of example 12, further comprising one or more thermistors coupled to the inner housing, and wherein the processing circuitry is configured to receive the electrical signal from the one or more thermistors.

Example 14: the system of any of examples 12 or 13, wherein the processing circuitry is configured to: receive a first voltage potential from the first surface of the TEC; receive a second voltage potential from the second surface of the TEC; determine a voltage potential difference between the first voltage potential and the second voltage potential; and determine, based on the voltage potential difference, the temperature of the inner housing.

Example 15: the system of any of examples 12-14, wherein the threshold temperature comprises a threshold temperature range, and wherein to determine that the determined temperature does not satisfy the threshold temperature, the processing circuitry is configured to determine that the determined temperature is outside of the threshold temperature range.

Example 16: the system of example 15, wherein the processing circuitry is configured to: compare the determined temperature against a maximum threshold temperature of the threshold temperature range; and in response to a determination that the determined temperature is greater than or equal to the maximum threshold temperature, cause the generator circuitry to deliver the DC electric current to the TEC to cause the TEC to transfer thermal energy to one or more locations along the inner housing or the outer housing.

Example 17: the system of any of examples 15 or 16, wherein the processing circuitry is configured to: compare the determined temperature against a minimum threshold temperature of the threshold temperature range; and in response to a determination that the determined temperature is less than or equal to the minimum threshold temperature, cause the generator circuitry to deliver the DC electric current to the TEC to cause the TEC to transfer thermal energy to one or more locations along the inner housing or the outer housing.

Example 18: the system of any of examples 12-17, wherein the system comprises a plurality of TECs disposed between the inner housing and the outer housing, each of the plurality of TECs being coupled to the processing circuitry, and wherein the processing circuitry is configured to: receive one or more of voltage potentials or current values from each TEC of the plurality of TECs; determine, based on the one or more voltage potentials or the current values from each TEC of the plurality of TECs, the temperature at one or more locations along the inner housing or the outer housing sensed by each TEC; compare, for each TEC, the temperature against the threshold temperature; and in response to a determination that the determined temperatures sensed by one or more TECs of the plurality of TECs do not satisfy the threshold temperature, cause generator circuitry to deliver the DC electric current to the one or more TECs to modulate the temperature of at least one location inner housing or the outer housing, the at least one location corresponding to the one or more TECs.

Example 19: the system of any of examples 12-18, wherein the TEC is configured to shield the electronic device from one or more of electromagnetic radiation or electrostatic discharge (ESD).

Example 20: the system of any of examples 12-19, wherein the electronic device comprises one or more of an accelerometer or a gyroscope.

## Claims

1. A system comprising:
an inner housing;
an electronic device disposed within the inner housing, wherein the electronic device comprises one or more of an accelerometer or a gyroscope;
an outer housing disposed radially outwards of the inner housing relative to an axis of the inner housing; and
a thermoelectric cooler (TEC) disposed between the inner housing and the outer housing, the TEC comprising:
a first surface thermally coupled to the inner housing, and
a second surface thermally coupled to the outer housing,
wherein the TEC is configured to, in response to application of DC electrical current, transfer thermal energy between the TEC and the inner housing and between the TEC and the outer housing to modulate temperature of the electronic device, and
wherein the inner housing defines a first geometry, wherein the outer housing defines a second geometry, and wherein the first surface of the TEC is shaped to conform to the first geometry and the second surface of the TEC is shaped to conform to the second geometry.

2. The system of claim 1, wherein the TEC is configured to:
in response to the application of DC electrical current with an initial polarity, transfer a negative thermal energy from the TEC to the inner housing and a positive thermal energy from the TEC to the outer housing, and
in response to the application of DC electrical current with a reversed polarity, transfer a positive thermal energy from the TEC to the outer housing and a negative thermal energy from the TEC to the inner housing, wherein the initial polarity is different from the reversed polarity.

3. The system of any of claims 1 or 2, wherein the first geometry is different from the second geometry.

4. The system of any of claims 1-3, wherein the electronic device comprises:
generator circuitry electrically coupled to the TEC and configured to deliver the DC electrical current to the TEC; and
processing circuitry electrically coupled to the generator circuitry and to the TEC, the processing circuitry being configured to:
receive electrical signals from the TEC;
determine, based on the electrical signals, a temperature value sensed by the TEC;
compare the temperature value of the TEC against a threshold temperature value; and
in response to a determination that the temperature value of the TEC does not satisfy the threshold temperature value, cause the generator circuitry to deliver the DC electrical current to the TEC.

5. The system of claim 4,
wherein the electrical signals from the TEC indicates a first voltage potential at the first surface and a second voltage potential at the second surface, and
wherein to determine the temperature value sensed by the TEC, the processing circuitry is configured to:
determine, based on the first voltage potential and the second voltage potential, a voltage potential difference between the first surface and the second surface of the TEC; and
determine, based on the voltage potential difference, one or more of:
a temperature difference between the inner housing and the outer housing,
a first temperature of the inner housing, or
a second temperature of the outer housing.

6. The system of any of claims 1-5, wherein the outer housing is configured to shield the electronic device and the TEC from one or more of electromagnetic radiation or electrostatic discharge (ESD).

7. The system of any of claims 1-6, wherein the electronic device comprises a resonating beam accelerometer.

8. A system comprising:
an inner housing;
an electronic device disposed within the inner housing, the electronic device comprising processing circuitry and generator circuitry;
an outer housing disposed radially outwards of the inner housing relative to an axis of the inner housing; and
a thermoelectric cooler (TEC) disposed between the inner housing and the outer housing, the TEC comprising:
a first surface thermally coupled to the inner housing, and
a second surface thermally coupled to the outer housing,
wherein the processing circuitry is coupled to the TEC, and wherein the processing circuitry is configured to:
receive electrical signals corresponding to a temperature of the inner housing;
determine the temperature of the inner housing based on the received electrical signals;
compare the determined temperature against a threshold temperature; and
based on a determination that the determined temperature does not satisfy the threshold temperature, cause the generator circuitry to deliver DC electric current to the TEC to cause the TEC to transfer thermal energy between the TEC and one or more locations of the inner housing and between the TEC and the outer housing to modulate the temperature of the inner housing.

9. The system of claim 8, further comprising one or more thermistors coupled to the inner housing, and wherein the processing circuitry is configured to receive the electrical signal from the one or more thermistors.

10. The system of any of claims 8 or 9, wherein the processing circuitry is configured to:
receive a first voltage potential from the first surface of the TEC;
receive a second voltage potential from the second surface of the TEC;
determine a voltage potential difference between the first voltage potential and the second voltage potential; and
determine, based on the voltage potential difference, the temperature of the inner housing.

11. The system of any of claims 8-10,
wherein the threshold temperature comprises a threshold temperature range, and
wherein to determine that the determined temperature does not satisfy the threshold temperature, the processing circuitry is configured to determine that the determined temperature is outside of the threshold temperature range.

12. The system of claim 11, wherein the processing circuitry is configured to:
compare the determined temperature against a maximum threshold temperature of the threshold temperature range; and
in response to a determination that the determined temperature is greater than or equal to the maximum threshold temperature, cause the generator circuitry to deliver the DC electric current to the TEC to cause the TEC to transfer thermal energy to one or more locations along the inner housing or the outer housing.

13. The system of claim 11, wherein the processing circuitry is configured to:
compare the determined temperature against a minimum threshold temperature of the threshold temperature range; and
in response to a determination that the determined temperature is less than or equal to the minimum threshold temperature, cause the generator circuitry to deliver the DC electric current to the TEC to cause the TEC to transfer thermal energy to one or more locations along the inner housing or the outer housing.

14. The system of any of claims 8-13,
wherein the system comprises a plurality of TECs disposed between the inner housing and the outer housing, each of the plurality of TECs being coupled to the processing circuitry, and
wherein the processing circuitry is configured to:
receive one or more of voltage potentials or current values from each TEC of the plurality of TECs;
determine, based on the one or more voltage potentials or the current values from each TEC of the plurality of TECs, the temperature at one or more locations along the inner housing or the outer housing sensed by each TEC;
compare, for each TEC, the temperature against the threshold temperature; and
in response to a determination that the determined temperatures sensed by one or more TECs of the plurality of TECs do not satisfy the threshold temperature, cause generator circuitry to deliver the DC electric current to the one or more TECs to modulate the temperature of at least one location inner housing or the outer housing, the at least one location corresponding to the one or more TECs.

15. The system of any of claims 8-14, wherein the TEC is configured to shield the electronic device from one or more of electromagnetic radiation or electrostatic discharge (ESD).
